# EUROPEAN PATENT SPECIFICATION

(11) **EP 1 574 867 B1**
(45) Date of publication and mention of the grant of the patent: **08.08.2007**
(21) Application number: 03780824.3
(22) Date of filing: 17.12.2003
(51) Int. Cl.: G01R 31/317, G01R 31/319

(54) **SEMICONDUCTOR DEVICE AND METHOD FOR TESTING THE SAME**
HALBLEITERBAUELEMENT UND VERFAHREN ZU SEINER PRÜFUNG
DISPOSITIF A SEMI-CONDUCTEUR ET SON PROCEDE D'ESSAI

(30) Priority: 20.12.2002 JP 2002370274
(43) Date of publication of application: 14.09.2005
(73) Proprietor: FUJITSU LIMITED, Kawasaki-shi, Kanagawa 211-8588 (JP)
(72) Inventor: FURUYAMA, Takaaki, c/o Spansion Japan Limited, Fukushima 965-0845 (JP)
(74) Representative: Brookes Batchellor LLP
(86) International application number: PCT/JP2003/016156
(87) International publication number: WO 2004/057353

(56) References cited:
- JP-A- 11 297 100
- JP-A- 2001 312 900
- US-A- 5 673 270
- US-A- 5 825 712
- US-A1- 2001 001 261
- US-A1- 2001 009 524
- PATENT ABSTRACTS OF JAPAN vol. 014, no. 585 (P-1148), 27 December 1990 (1990-12-27) -& JP 02 252199 A (NEC CORP), 9 October 1990 (1990-10-09)

## Description

### TECHNICAL FIELD

The present invention relates to a semiconductor device having a logic section and a memory section mounted together on a single chip and a test method thereof.

In the recent trend of high integration of semiconductor devices (LSIs), such as ASICs and microprocessors, LSIs have become to have a macro memory (memory section) mounted together with a logic section on the same chip. Such memory-mixed LSIs are subjected to a performance test before shipping to check whether the logic sections and macro memories operate normally. There is a demand for technology that shortens the test time for macro memories with a simple circuit configuration.

### BACKGROUND ART

In a memory-mixed LSI, ordinary operations (write operation and read operation) of a macro memory are controlled by a signal from a logic section. For example, when a read command is issued from the logic section, the macro memory is provided with an address together with this command, and data selected based on this address is output from the macro memory to the logic section. When a write command is issued from the logic section, the macro memory is provided with an address and data together with this command, and the macro memory writes the data in a storage area selected based on the address.

As the methods for testing a macro memory in the memory-mixed LSI configured in this manner, the following two methods are known.

The first one is a method to conduct a test by controlling the operation of the macro memory by the use of the logic section without any special test circuit.

The second one is a method in which the macro memory is tested without using the logic section by incorporating an exclusive test circuit exclusively and providing test I/O terminals so that a test signal is provided from the test input terminal to operate the test circuit. As such test circuit, a BIST (built-in self-test) circuit is known.

If the macro memory is tested by using the logic section as in the first method, the logic section must function to perform processing for entering the test mode. This leads to a longer test time, and hence the first method is not practical. Therefore, many memory-mixed LSIs provided with a built-in test circuit in accordance with the second method have come into practical use.

A test circuit incorporated in a memory-mixed LSI is principally comprised of a multiplexer for switching a signal transferred between a logic section and a macro memory during normal operation and a test signal provided from test I/O terminals.

As the test I/O terminals, there are provided terminals for inputting and outputting signals required for controlling the macro memory by means of the logic section during normal operation (address signals, data signals, and other control signals), and the macro memory is tested by a method referred to as direct access method (see patent document 1). When a test is conducted with the direct access method, all the signals defined in the operational specification of the macro memory (address signals, data signals, and control signals) are required as the test signals.

Patent document 2 discloses a method of testing a macro memory by coding control signals, except for address signals and data signals, and providing the codes to a test circuit through test terminals.

Further, patent document 3 discloses a technique to shorten the test time by providing a plurality of test pads directly connected to a memory by a test entry signal, and concentrating the pads along one side of a chip to increase the number of chips that can be tested at a time.

However, such conventional memory-mixed LSI provided with a test circuit requires a circuit for decoding a test code and a plurality of test terminals for providing test signals. This increases the circuit area, which leads to a problem that the die size of the LSI is increased.

It is an object of the present invention to provide a semiconductor device and a test method thereof capable of shortening the test time with a simple circuit configuration and preventing an increase in the circuit area used for testing.

Patent Document 1: Japanese Laid-Open Patent Publication No. 10-65104 (Fig. 12)

Patent Document 2: Japanese Laid-Open Patent Publication No. 11-250700

Patent Document 3: Japanese Laid-Open Patent Publication No. 2000-57120

JP-2-252199 and US-A-5673270 are concerned with the testing of semiconductor memories.

### DISCLOSURE OF THE INVENTION

According to the present invention there is provided semiconductor device provided with a test mode, in accordance with claim 1.

According to the present invention there is also provided a test method for a semiconductor device, in accordance with claim 11.

### BRIEF DESCRIPTION OF THE DRAWING

Fig. 1 is a schematic block diagram showing a semiconductor device according to an embodiment of the present invention.
Fig. 2 is a schematic block circuit diagram showing a macro memory of the semiconductor device of Fig. 1.
Fig. 3 is an explanatory diagram showing a memory map of the macro memory of Fig. 2.
Fig. 4 is a schematic circuit diagram showing a test entry detection circuit of the macro memory of Fig. 2.
Fig. 5 is a schematic circuit diagram showing a test mode selection circuit of the macro memory of Fig. 2.
Fig. 6 is a schematic circuit diagram of a test code write circuit of the macro memory of Fig. 2.
Fig. 7 is a schematic circuit diagram showing a test register of the macro memory of Fig. 2.
Fig. 8 is a schematic circuit diagram showing a macro I/O selector of the macro memory of Fig. 2.
Fig. 9 is a schematic circuit diagram of an analog switch of the macro I/O selector of Fig. 8.

### BEST MODE FOR CARRYING OUT THE INVENTION

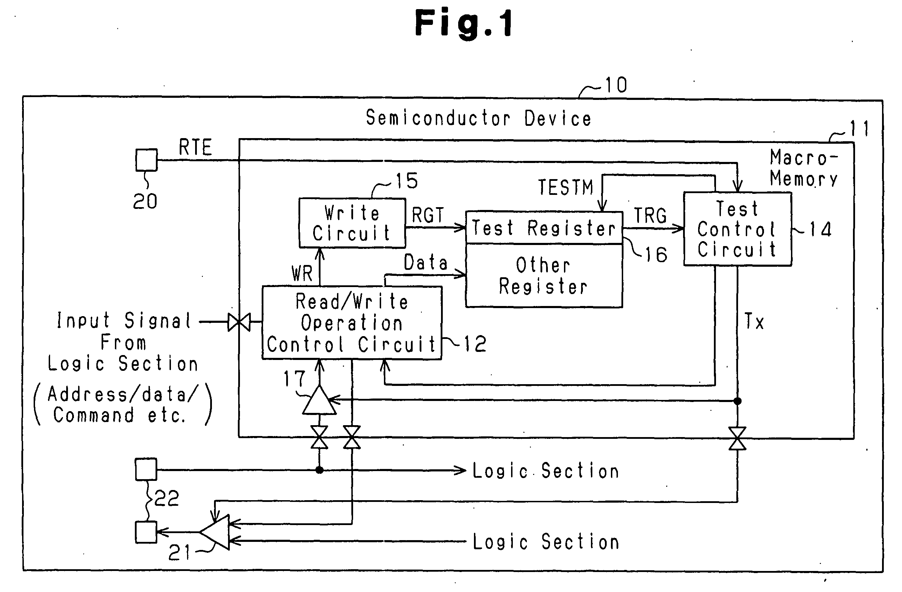

Fig. 1 is a schematic block diagram showing a semiconductor device 10 according to an embodiment of the present invention. The semiconductor device 10 includes a memory section (macro memory) 11 that is mounted together with a logic section. The macro memory 11 is provided with an operation control circuit 12 for performing a data read/write operation based on an input signal containing an address, data, and a command. A test memory circuit 16 for storing data to select a test mode is provided in a storage area (address space) selected by the address contained in the input signal. A write circuit 15 provides a control signal RGT, which enables writing of data to the test memory circuit 16, in response to a write command WR provided from the operation control circuit 12. The data Data contained in the input signal is written to the test memory circuit 16 based on the control signal RGT.

The operation control circuit 12 is a circuit for accessing register area and memory area of the macro memory 11 based on an input signal from the logic section. The test memory circuit 16 is a test register provided in the register area. In other words, the test register 16 is allocated to the same address space as the memory area. A test code for selecting a test mode is written to the test register 16 in the same manner as when data is written to the memory area.

An output signal TRG of the test register 16 is provided to a test control circuit 14 and decoded by the test control circuit 14. The test control circuit 14 outputs a predetermined test mode select signal Tx corresponding to the output signal TRG from the test register 16.

The test mode select signal Tx of the test control circuit 14 is provided to an I/O selector 17. The I/O selector 17 selects and outputs one of a plurality of internal signals based on the test mode select signal Tx.

The test control circuit 14 is provided with a test entry signal RTE via a test entry terminal 20 provided outside of the macro memory 11. The test entry signal RTE has a higher voltage than an operational voltage of the macro memory 11, and the test control circuit 14 is provided with a detection circuit for detecting high voltage.

When detecting an input of the test entry signal RTE, the test control circuit 14 provides a test activation signal TESTM to the test register 16. The test activation signal TESTM enables writing of data to the test register 16.

A test method for the macro memory 11 includes the following first to third steps. In the first step, a test entry signal RTE is provided to the macro memory 11 via an external test entry terminal 20. In the second step, by the write operation of the operation control circuit 12, data is written to the test register 16 provided in a storage area that is selectable by an address. In the third step, a test mode is selected to test the macro memory 11 based on the output signal TRG from the test register 16.

The test entry signal is a signal having a higher voltage than an operational voltage of the macro memory 11, and a high voltage signal is detected in the first step. The data written in the test register 16 in the second step is a coded test code, and the output signal TRG from the test register 16 is decoded in the third step.

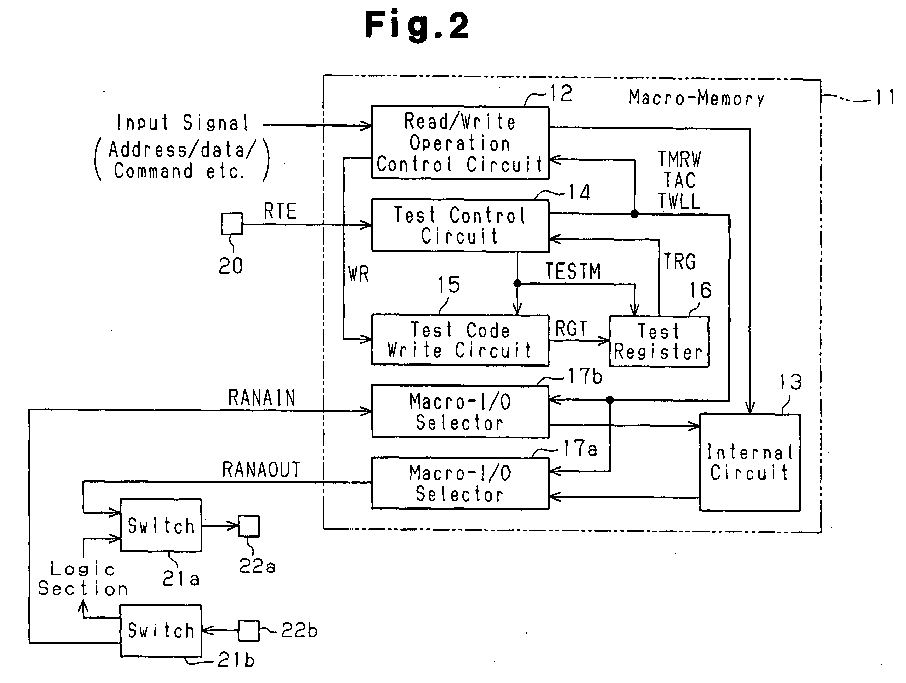

Fig. 2 is a schematic block circuit diagram of the macro memory 11. The macro memory 11 is mounted on the single-chip semiconductor device (LSI) 10 together with the logic section. The semiconductor device 10 has a data storing function and other functions (for example, A/D conversion function).

The macro memory 11 includes the read/write operation control circuit 12, an internal circuit 13, the test control circuit 14, the test code write circuit 15, the test register 16, and macro I/O selectors 17a and 17b.

The read/write operation control circuit 12 is provided with an input signal, such as an address/data/command or the like, from the logic section. The read/write operation control circuit 12 controls the data read and write operations in the macro memory 11 based on the input signal.

The internal circuit 13 includes a plurality of memory cells for storing data and a circuit (such as an X decoder, a Y decoder, and a read amplifier) for accessing the memory cells. In the present embodiment, the memory cells provided in the internal circuit 13 are nonvolatile memory cells.

The test control circuit 14 is provided with a test entry signal RTE from the test entry terminal 20. The test entry terminal 20 is a package pin (external terminal) of the semiconductor device. The test entry signal RTE has a voltage (e.g. about 10V), which is higher than the operational voltage of the macro memory 11 (e.g. 3V), and is provided from a test apparatus (not shown) connected to the test entry terminal 20.

Upon detecting a high-voltage test entry signal RTE, the test control circuit 14 provides a test activation signal TESTM to the test code write circuit 15 and the test register 16.

Upon receiving the activation signal TESTM from the test control circuit 14 and further receiving a register write command WR from the read/write operation control circuit 12, the test code write circuit 15 provides a write control signal RGT to the test register 16. In response to the control signal RGT, the test register 16 stores the data contained in the input signal as a test code.

The test register 16 provides the test control circuit 14 with an output signal TRG corresponding to the stored test code. The test control circuit 14 decodes the output signal TRG from the test register 16 and selects a test mode. The test control circuit 14 provides a test mode select signal (one of signals TMRW, TAC, and TWLL) to the read/write operation control circuit 12 and the macro I/O selectors 17a and 17b.

The test mode select signal TMRW is a signal for conducting a data read test of the memory cells by adjusting voltage of the floating gate of a test reference cell, and the test mode select signal TAC is a signal for conducting a test to measure electric current flowing through the memory cells. The test mode select signal TWLL is a signal for conducting a test to detect leakage from a word line.

The read/write operation control circuit 12 determines the type of the provided test mode select signal and provides the internal circuit 13 with a signal according to the test mode. The signal provided from the read/write operation control circuit 12 to the internal circuit 13 includes an address, data, and a command.

The macro I/O selector 17a provides a signal from the internal circuit 13 (such as data read from the memory cells or an internal signal) to a switch 21a as an output signal RANAOUT, in accordance with the test mode select signal. The macro I/O selector 17b provides an input signal RANAIN to the internal circuit 13 via a switch 21b, in accordance with the test mode select signal.

The switches 21a and 21 are provided outside of the macro memory 11 and connected to external terminals 22a and 22b, respectively. The external terminals 22a and 22b are used commonly by the macro memory 11 and the logic section. That is, the respective connections of the external terminals 22a and 22b are switched between the macro memory 11 and the logic section by the switches 21a and 21b.

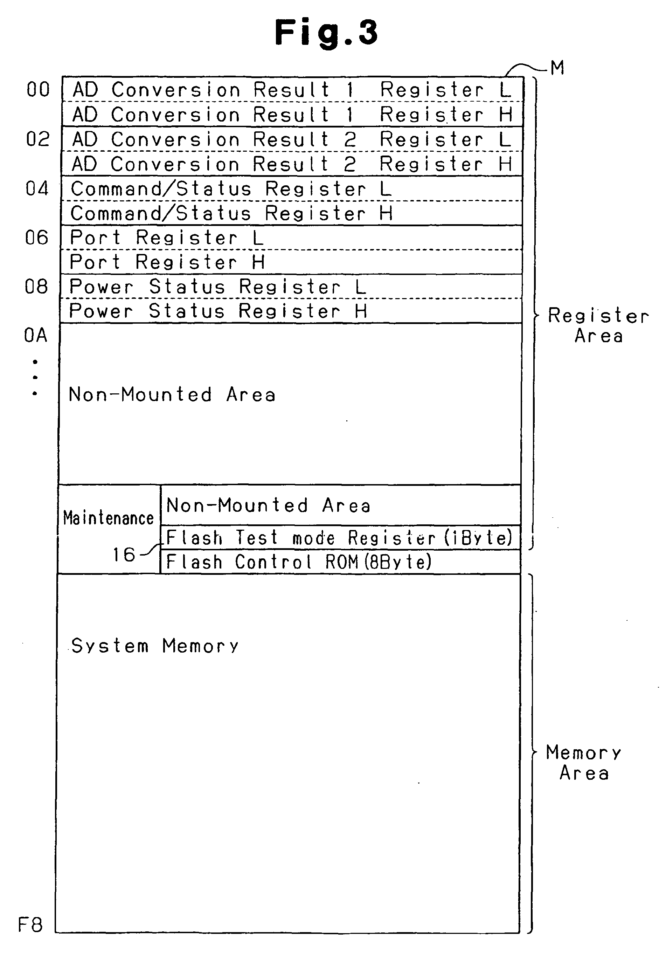

Fig. 3 is a memory map M in the macro memory 11 of the present embodiment. The address space in the memory map M is divided into a register area and a memory area. A system memory which is a nonvolatile memory is allocated as the memory area.

Registers allocated to the register area include an A/D conversion register for saving an A/D conversion result, a command/status register for storing a command to start A/D conversion and a conversion status, a port register for designating a port output level, and a power status register for indicating a power source condition. The test register 16 for saving a test code is mapped in the register area used for maintenance.

In the present embodiment, the register area is a volatile storage area and separated from the nonvolatile memory area in the macro memory 11. When accessing the register area from the outside of the macro memory 11, an input signal, such as an address/data/command or the like, is provided to the macro memory 11 in the same manner as when accessing the memory area. When accessing the test register 16 for writing the test code, the test entry terminal 20 is activated (high-voltage test entry signal RTE is provided), and the address/data/command are provided in the same manner as when accessing the memory area.

The configuration of each circuit in the macro memory 11 will now be described in detail.

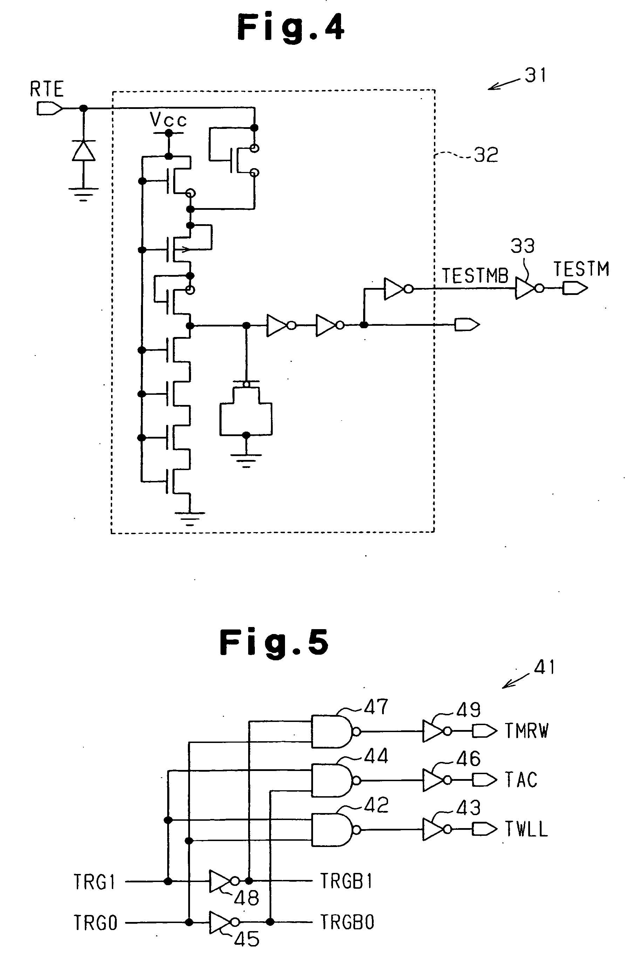

The test control circuit 14 according to the present embodiment includes a test entry detection circuit 31 shown in Fig. 4 and a test mode selection circuit 41 shown in Fig. 5.

As shown in Fig. 4, the test entry detection circuit 31 has a high-voltage detection circuit 32 for detecting high voltage. The high-voltage detection circuit 32 is configured to include a plurality of MOS transistors, and an output signal TESTMB is inverted by a buffer (more specifically, an inverter circuit) 33 and output as a test activation signal TESTM. The test entry detection circuit 31 outputs an H level test activation signal TESTM when provided with a test entry signal RTE having a higher voltage value than a power supply Vcc, and outputs an L level test activation signal TESTM when not provided with a test entry signal RTE.

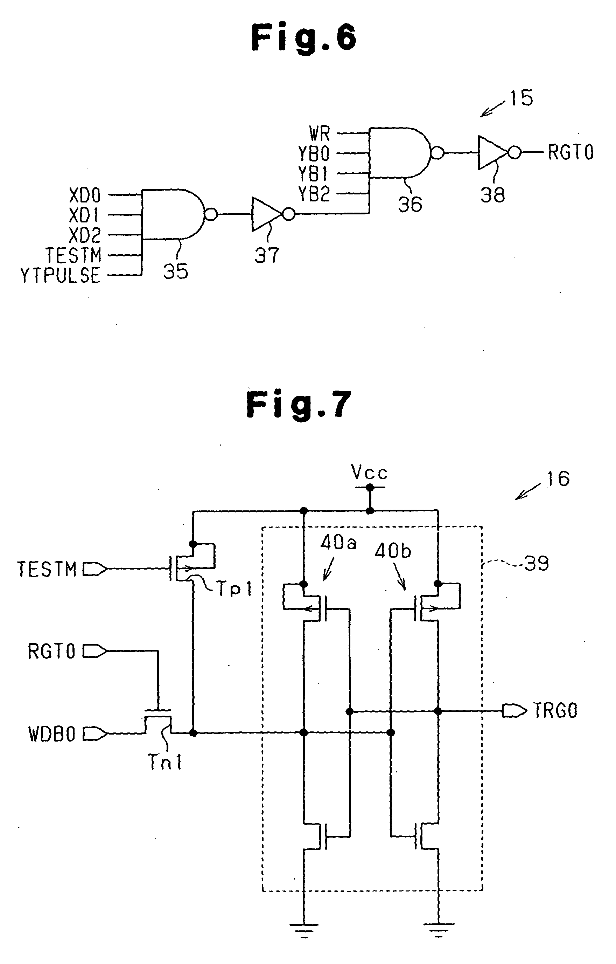

As shown in Fig. 6, the test code write circuit 15 has NAND circuits 35 and 36 and inverter circuits 37 and 38. Address signals XD0 through XD2 are provided to first to third input terminals of the NAND circuit 35, a test activation signal TESTM is provided to a fourth input terminal of the NAND circuit 35, and a data retrieval signal YTPULSE is provided to a fifth input terminal of the NAND circuit 35.

A register write command WR is provided to a first input terminal of the NAND circuit 36, address signals YB0 through YB2 are provided to second to fourth input terminals of the NAND circuit 36, and an output signal from the NAND circuit 35 is provided to a fifth input terminal of the NAND circuit 36 via an inverter circuit 37. An output signal of the NAND circuit 36 is output via an inverter circuit 38 as a control signal RGT0.

In the test code write circuit 15, when all of the input signals XD0 through XD2, TESTM, YTPULSE, WR, and XB0 through XB2 have an H level, the control signal RGT0 shifts to the H level, and when any of the input signals has an L level, the control signal RGT0 shifts to the L level.

Fig. 7 is a partial circuit diagram showing the test register 16. Fig. 7 shows a circuit for storing one bit of data, and the test register 16 has a plurality of such circuits as shown in Fig. 7 for storing other bits of data.

The test register 16 has a data latch circuit 39, and write data WDB0 provided via an NMOS transistor Tn1 is stored in the data latch circuit 39. A control signal RGT0 from the test code write circuit 15 is provided to the gate of the NMOS transistor Tnl, and the NMOS transistor Tn1 is turned on by an H level control signal RGT0.

The data latch circuit 39 is configured by first and second inverter circuits 40a and 40b. Each of the inverter circuits 40a and 40b is configured by a PMOS transistor and an NMOS transistor connected in series between the power supply Vcc and the ground. The output terminal of the first inverter circuit 40a (node between the drains of the PMOS and NMOS transistors) is connected to the input terminal of the second inverter circuit 40b (node of the gates of the respective transistors). The output terminal of the second inverter circuit 40b is connected to the input terminal of the first inverter circuit 40a.

The node between the data latch circuit 39 and the NMOS transistor Tn1 is connected to the power supply Vcc via a PMOS transistor Tp1. A test activation signal TESTM is provided to the gate of the PMOS transistor Tp1 so that the transistor Tp1 is controlled by the test activation signal TESTM.

In the test register 16, the PMOS transistor Tp1 is turned off by an H level test activation signal TESTM. When the NMOS transistor Tn1 is turned on by an H level control signal RGT0, write data WDB0 is latched in the data latch circuit 39 via the transistor Tn1. A latch signal from the data latch circuit 39 is provided to the test control circuit 14 as an output signal TRG0 from the test register 16. The output signal TRG0 is a signal of an inverted logic level with respect to the write data WDB0. More specifically, if the write data WDB0 has an L level, the H level output signal TRG0 is output.

If the test activation signal TESTM has an L level, the PMOS transistor Tp1 is turned on and the control signal RGT0 shifts to an L level. This turns off the NMOS transistor Tn1. Therefore, when the test activation signal TESTM has an L level, the input signal to the data latch circuit 39 always has an H level, and the output signal TRG0 output from the data latch circuit 39 shifts to an L level.

As shown in Fig. 5, the output signals TRG0 and TRG1 of the test register 16 are provided to the test mode selection circuit 41. In the test mode selection circuit 41, the signal TRG0 is provided to one of the input terminals of a first NAND circuit 42, and the signal TRG1 is provided to the other one of the input terminals of the first NAND circuit 42. An output signal from the first NAND circuit 42 is output from the test mode selection circuit 41 via an inverter circuit 43 as the test mode select signal TWLL.

A signal TRGB0 obtained by inverting the signal TRG0 with an inverter circuit 45 is provided to one of the input terminals of a second NAND circuit 44, and the signal TRG1 is provided to the other one of the input terminals of the second NAND circuit 44. An output signal of the second NAND circuit 44 is output from the test mode selection circuit 41 via an inverter circuit 46 as the test mode select signal TAC.

Further, the signal TRG0 is provided to one of the input terminals of a third NAND circuit 47, and a signal TRGB1 obtained by inverting the signal TRG1 with an inverter circuit 48 is provided to the other one of the input terminals of the third NAND circuit 47. An output signal of the third NAND circuit is output from the test mode selection circuit 41 via an inverter circuit 49 as the test mode select signal TMRW.

Accordingly, if the signals TRG0 and TRG1 have an H level, the test mode select signal TWLL shifts to an H level and the other select signals TAC and TMRW shift to an L level. If the signal TRG0 has an L level and the signal TRG1 has an H level, the test mode select signal TAC shifts to an H level and the other select signals TWLL and TMRW shifts to an L level. Further, if the signal TRG0 has an H level and the signal TRG1 has an L level, the test mode select signal TMRW shifts to an H level and the other select signals TWLL and TAC shift to an L level.

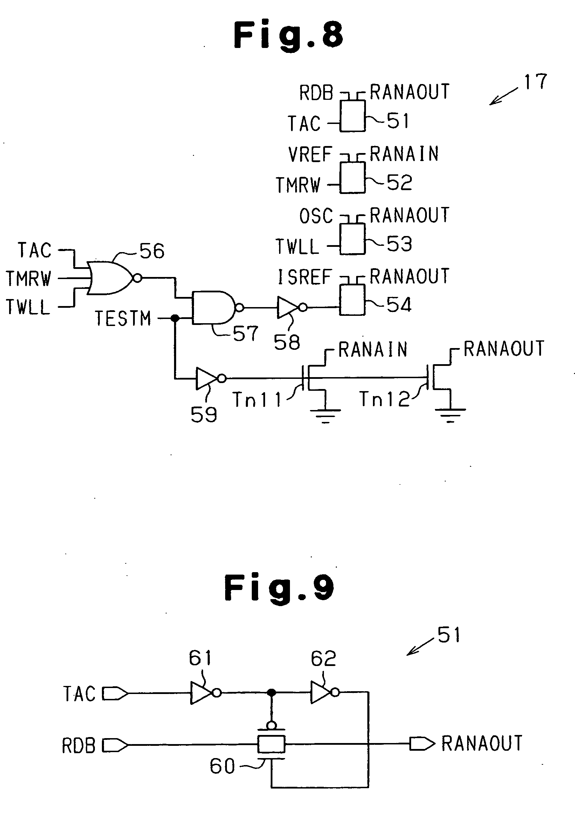

As shown in Fig. 8, the test mode select signals TAC, TMRW, and TWLL are provided to the macro I/O selector 17 (17a and 17b). The macro I/O selector 17 has four analog switches 51 through 54 so that one of the analog switches 51 through 54 is turned on based on the select signals TAC, TMRW, and TWLL. Thus, one is selected from among a plurality of internal signals (signals output from the internal circuit 13 to the outside of the macro memory 11) and external signals (signals input from the outside of the macro memory 11 to the internal circuit 13).

Fig. 9 shows a specific circuit configuration of the analog switch 51. The analog switch 51 has a transfer gate 60, which is configured by an NMOS transistor and a PMOS transistor, and inverter circuits 61 and 62. The test mode select signal TAC is provided to the PMOS transistor gate of the transfer gate 60 via an inverter circuit 61 and also to the NMOS transistor gate of the transfer gate 60 via the inverter circuit 61 and the inverter circuit 62.

Accordingly, if the test mode select signal TAC has an H level, the transfer gate 60 is turned on (the analog switch 51 is turned on). Thus, a signal in a data bus RDB (value of current flowing through the data bus) is output to the outside of the macro memory 11 as an output signal RANAOUT. Thus, a test is conducted to measure the current flowing through the memory cells.

The other analog switches 52 through 54 have the same circuit configuration as the analog switch 51 shown in Fig. 9. That is, if the test mode select signal TMRW has an H level, the analog switch 52 is turned on. This provides an input signal RANAIN from the outside of the macro memory 11 to the internal circuit 13 as a set signal for setting the voltage at the floating gate of a test reference cell.

If the test mode select signal TWLL has an H level, the analog switch 53 is turned on. This outputs an oscillation signal OSC of an oscillator in the internal circuit 13 from the macro memory 11 as an output signal RANAOUT.

A control signal for turning the analog switch 54 on is generated by a NOR circuit 56, a NAND circuit 57, and an inverter circuit 58. More specifically, the test mode select signals TAC, TMRW, and TWLL are provided to the first to third input terminals of the NOR circuit 56, respectively. An output signal of the NOR circuit 56 is provided to a first input terminal of the NAND circuit 57, while a test activation signal TESTM is provided to a second input terminal of the NAND circuit 57. An output signal of the NAND circuit 57 is inverted via the inverter circuit 58 and provided as a control signal for the analog switch 54.

Accordingly, if all the test mode select signals TAC, TMRW, and TWLL have an L level and the test activation signal TESTM has an H level, the analog switch 54 is turned on. This outputs a reference current ISREF flowing to a sense amplifier in the internal circuit 13 from the macro memory 11 as an output signal RANAOUT.

In the macro I/O selector 17, the test activation signal TESTM is provided to the gates of NMOS transistors Tn11 and Tn12 via an inverter circuit 59. If the test activation signal TESTM has an L level, the transistor Tn11 is turned on to set the input signal RANAIN to the ground level, and the transistor Tn12 is turned on to set the output signal RANAOUT to the ground level.

A test method for the macro memory 11 includes the following first to third steps.

In the first step, a test apparatus, which is not shown in the drawings, provides a high-voltage test entry signal RTE to the test entry terminal 20. The test entry signal RTE is provided to the test control circuit 14 in the macro memory 11. When detecting an input of the high-voltage test entry signal RTE at the test entry detection circuit 31, the test control circuit 14 provides a test activation signal TESTM to the test code write circuit 15 and the test register 16. The test activation signal TESTM enables writing of a test code to the test register 16.

In the second step, the test code is written to the test register 16 by the write operation of the read/write operation control circuit 12. In this state, the test register 16, to which the test code is to be written, is designated based on an address included in the input signal from the logic section, and the data included in the input signal is stored in the test register 16 as the test code.

In the third step, the output signals TRG0 and TRG1 of the test register 16 are decoded by the test mode selection circuit 41 of the test control circuit 14 to select a test mode. The test control circuit 14 outputs select signals TAC, TMRW, and TWLL according to the selected test mode. Based on these select signals, the macro I/O selectors 17a and 17b select one the plurality of signals. Further, the macro I/O selectors 17a and 17b are connected to the external terminal 22a and 22b by the switches 21a and 21b, respectively to conduct a desired performance test on the macro memory 11.

During testing, the macro memory 11 is accessed when an input signal (address/data/command) is appropriately provided from the logic section. More specifically, a data write command or read command, and an address and data corresponding to the command are provided and a desired internal signal (including read data) is output from the internal circuit 13 via the macro I/O selector 17.

The semiconductor device of the present embodiment has the following advantages.
(1) The test register 16 is arranged in the register area of the macro memory 11, and a test code is written to the test register 16 in the same manner as when accessing other register areas. That is, the interface used for providing the address/data/command to the macro memory 11 from the logic section when writing to the test register 16 is the same as that used for accessing other registers. In this case, the processing time for writing a test code to the test register 16 is short. As a result, the test time for the macro memory 11 is shortened with a simple configuration and enlargement of the circuit area used for conducting the test is prevented.
(2) In the macro memory 11, the test mode selection circuit 41 is provided for decoding the output signals (register signals) TRG0 and TRG1 of the test register 16, and the test mode select signals TMRW, TAC, and TWLL according to the test code of the test register 16 are output from the test mode selection circuit 41. According to such configuration, the logic section does not have to be provided with an additional function of decoding a test command or the like to test the macro memory 11, and no sequence is required due to generation of a new command. More specifically, the need to add a new command for testing is eliminated by using a read command for a test which requires data to be output and by using a write command for a test which requires data to be input.
(3) The macro I/O selectors 17a and 17b are provided to select and output one of a plurality of internal signals based on the test mode select signals TAC, MRW, and TWLL, which are output from the test mode selection circuit 41. The switches 21a, 21b are provided outside of the macro memory 11 to select either a signal from the macro memory 11 or a signal from the logic section. By providing the macro I/O selectors 17a and 17b and the switches 21a and 21b, the input and output of signals required for testing the macro memory 11 via the external terminals 22a and 22b are enabled. The external terminals 22a and 22b are used commonly by the logic section and the macro memory 11. Therefore, the number of external terminals 22 required for testing is prevented from being increased.
(4) The test entry signal RTE has a higher voltage than an operational voltage of the macro memory 11, and when the test entry detection circuit 31 of the macro memory 11 detects that the test entry signal RTE has been provided, the test activation signal TESTM is provided to the test code write circuit 15 and the test register 16. The test activation signal TESTM enables writing of a test code to the test register 16. This ensures prevention of erroneous writing to the test register 16.

The above embodiments may be modified as follows.

The test entry detection circuit 31 may be arranged outside of the macro memory 11. In this case, the test activation signal TESTM of the test entry detection circuit 31 is provided to the circuits 15 and 16 of the macro memory 11.

Data stored in the test register 16 may be output directly as a test mode select signal without being decoded bit by bit. However, it is desirable from a practical viewpoint to decode the test code as in the embodiment since several types of test modes can be stored in the test register 16, which is a limited storage area.

The test code may be stored in a nonvolatile memory area. In this case, the test code is held even if the power supply is shut off. Therefore, in a test mode which requires the power supply to be shut-off, the test time is shortened since the test code need not be rewritten.

## Claims

1. A semiconductor device provided with a test mode having a logic section and a memory section (11) mounted together thereon, the semiconductor device being **characterized in that** the memory section includes:
an operation control circuits (12) for receiving an input signal containing an address, data, and a command from the logic section, and executing a read/write operation of the data in accordance with the input signal;
a test memory circuit (16), connected to the operation control circuit(12) and provided in a storage area of the memory section (11) that is selectable by the address, for storing data to select the test mode (TMRW, TAC, TWLL); and
a write circuits (15), connected to the operation control circuit (12) and the test memory circuit (16), for generating a control signal and enabling writing of data to the test memory circuit (16) in response to a write command provided from the operation control circuit (12) in accordance with the input signal.

2. The semiconductor device according to claim 1, **characterized in that**:
the memory section(11) has a register area and a memory area;
the operation control circuit (12) accesses the register area and the memory area of the memory section in accordance with the input signal; and
the test memory circuit is a test register (16) provided in the register area and stores a coded test code (TRG) for selecting the test mode (TMRW, TAC, TWILL).

3. The semiconductor device according to claim 2, further **characterized by** a test control circuit (14), connected to the test register (16), for generating a test mode select signal (TMRW, TAC, TWLL) by decoding the test code (TRG) of the test register (16).

4. The semiconductor device according to claim 3, further **characterized by** an I/O selector (17a, 17b), connected to the test control circuit (14), for selecting one of a plurality of internal signals in accordance with the test mode select signal(TMRW, TAC, TWLL).

5. The semiconductor device according to claim 4, further **characterized by** a switch (21a, 21b), connected to the I/O selector (17a, 17b), for selecting either one of the signal selected by the selector and the signal of the logic section, the I/O selector being connected to an external terminal (22a, 22h) via the switch.

6. The semiconductor device according to claim 3, **characterized in that** the test control circuit (14) receives a test entry signal (RTE) from a test entry terminal(20) arranged outside of the memory section.

7. The semiconductor device according to claim 6, **characterized in that**:
the test entry signal (RTE) has a higher voltage than an operational voltage of the memory section; and
the test control circuit (14) includes a detection circuit (31) for detecting a high-voltage test entry signal.

8. The semiconductor device according to claim 7, **characterized in that** the detection circuit (31) generates a test activation signal (TESTM) when detecting the test entry signal (RTE), and provides the test activation signal to the test register (16).

9. The semiconductor device according to claim 1, **characterized in that**:
the memory section (13) includes a nonvolatile memory area;
the operation control circuit (12) accesses the nonvolatile memory area of the memory section (13) in accordance with the input signal; and
the test memory circuit (16)is arranged in the nonvolatile memory area.

10. A semiconductor device as claimed in claim 2, being a single-chip semiconductor having a macro memory mounted thereon.

11. A test method for a semiconductor device having a logic section and a memory section (11) mounted together thereon, the memory section including an operation control circuit (12) for receiving an input signal containing an address, data, and a command from the logic section and executing a read/write operation of the data, the test method being **characterized by**:
a first step of providing a test entry signal (RTE) to the memory section (11) through a test entry terminal (20);
a second step of writing the data to a test register (16), arranged in a storage area that is selectable by the address, in accordance with the write operation of the operation control circuit (12); and
a third step of selecting a test mode (TMRW, TAC, TWLL) to test the memory section in accordance with the data written to the test register.

12. The test method for a semiconductor device according to claim 11, **characterized in that**:
the test entry signal (RTE) has a higher voltage than an operational voltage of the memory section (11); and
the first step includes detecting a high-voltage test entry signal.

13. The test method for a semiconductor device according to claim 11, **characterized in that**:
the data written to the test register is a coded test code (TRGG) in the second step; and
the third step includes decoding the coded test code.

14. The test method for a semiconductor device according to claim 11, **characterized in that** the second step includes receiving the address for designating the test register (16).

15. The test method for a semiconductor device according to claim 11, **characterized in that** the second step includes receiving the data that is to be saved in the test register (16).

16. The test method for a semiconductor device according to claim 11, **characterized in that** the second step includes generating a control signal for enabling the writing of the data to the test register (16)in response to a write command provided from the operation control circuit, and providing the control signal to the test register.

17. The test method for a semiconductor device according to claim 11, **characterized in that** the third step includes receiving a write command or a read command for accessing the memory section (11).

18. The test method for a semiconductor device according to claim 11, **characterized in that** the third step includes receiving an address and data for accessing the memory section (11).

19. The test method for a semiconductor device according to claim 11, **characterized in that** the third step includes selecting one of a plurality of internal signals according to the data written to the test register (16).

20. The test method for a semiconductor device according to claim 19, **characterized in that** the third step includes selecting either one of the selected internal signal and a signal provided from the logic section.

21. The test method for a semiconductor device According to claim 11,
the second step comprising designating the test register with the address in correspondence with the test entry signal;
and the third step comprising writing data for selecting the test mode in the test register in correspondence with the test entry signal.

## Patentansprüche

1. Halbleiterbauelement mit einem Testmodus, wobei das Halbleiterbauelement darauf ausgebildet einen Logikabschnitt und einen Speicherabschnitt (11) aufweist, und wobei sich das Halbleiterbauelement dadurch auszeichnet, dass der Speicherabschnitt umfasst:
eine Betriebssteuerschaltung (12) zum Empfangen eines Eingangssignals von dem Logikabschnitt mit einer Adresse, Daten und einem Befehl, und zum Ausführen einer Lese/Schreib-Operation an den Daten gemäß dem Eingangssignal;
eine Testspeicherschaltung (16), die mit der Betriebssteuerschaltung (12) verbunden und in einem Speicherbereich des Speicherabschnitts (11) vorgesehen ist, der durch die Adresse auswählbar ist, um Daten zu speichern, um den Testmodus auszuwählen (TMRW, TAC, TWLL); und
eine Schreibschaltung (15), die mit der Betriebssteuerschaltung (12) und der Testspeicherschaltung (16) verbunden ist, um ein Steuersignal zu erzeugen und das Schreiben von Daten in die Testspeicherschaltung (16) in Reaktion auf einen Schreibbefehl, der von der Betriebssteuerschaltung (12) bereitgestellt wird, gemäß dem Eingangssignal zu aktivieren.

2. Halbleiterbauelement nach Anspruch 1, **dadurch gekennzeichnet, dass**:
der Speicherabschnitt (11) einen Registerbereich und einen Speicherbereich aufweist;
die Betriebssteuerschaltung (12) auf den Registerbereich und den Speicherbereich des Speicherabschnitts gemäß dem Eingangssignal zugreift; und
die Testspeicherschaltung ein Testregister (16) ist, das in dem Registerbereich vorgesehen ist, und eine codierte Testkodierung (TRG) zum Auswählen des Testmodus (TMRW, TAC, TWLL) speichert.

3. Halbleiterbauelement nach Anspruch 2, das ferner **gekennzeichnet ist durch** eine Teststeuerschaltung (14), die mit dem Testregister (16) verbunden ist, um ein Testmodusauswahlsignal (TMRW, TAC, TWLL) zu erzeugen, indem die Testkodierung (TRG) des Testregisters (16) dekodiert wird.

4. Halbleiterbauelement nach Anspruch 3, das ferner **gekennzeichnet ist durch** eine Eingabe/Ausgabe-Auswahleinrichtung (17a, 17b), die mit der Teststeuerschaltung (14) verbunden ist, um eines von mehreren internen Signalen entsprechend dem Testmodusauswahlsignal (TMRW, TAC, TWLL) auszuwählen.

5. Halbleiterbauelement nach Anspruch 4, das ferner **gekennzeichnet ist durch** eine Schalter (21a, 21b), die mit der Eingabe/Ausgabe-Auswahleinrichtung (17a, 17b) verbunden ist, um das von der Auswahleinrichtung ausgewählte Signal oder das Signal des Logikabschnitts auszuwählen, wobei die Eingabe/Ausgabe-Auswahleinrichtung mit einem externen Anschluss (22a, 22b) über den Schalter verbunden ist.

6. Halbleiterbauelement nach Anspruch 3, **dadurch gekennzeichnet, dass** die Teststeuerschaltung (14) ein Testeingangssignal (RTE) von einem Testeingangsanschluss (20), der außerhalb des Speicherabschnitts angeordnet ist, empfängt.

7. Halbleiterbauelement nach Anspruch 6, **dadurch gekennzeichnet, dass**:
das Testeingangssignal (RTE) eine höhere Spannung als eine Betriebsspannung des Speicherabschnitts aufweist; und
die Teststeuerschaltung (14) eine Erfassungsschaltung (31) zum Erfassen eines Hochspannungstesteingangssignals umfasst.

8. Halbleiterbauelement nach Anspruch 7, **dadurch gekennzeichnet, dass** die Erfassungsschaltung (31) ein Testaktivierungssignal (TESTM) erzeugt, wenn das Testeingangssignal (RTE) erfasst wird, und das Testaktivierungssignal dem Testregister (16) zuführt.

9. Halbleiterbauelement nach Anspruch 1, **dadurch gekennzeichnet, dass**:
der Speicherabschnitt (13) einen nicht-flüchtigen Speicherbereich aufweist;
die Betriebssteuerschaltung (12) auf den nicht-flüchtigen- Speicherbereich des Speicherabschnitts (13) gemäß dem Eingangssignal zugreift; und
die Testspeicherschaltung (16) in dem nicht-flüchtigen Speicherbereich angeordnet ist.

10. Halbleiterbauelement nach Anspruch 2, wobei das Bauelement ein Einzeichiphalbleiterbauelement mit einem Makrospeicher ist, der darauf ausgebildet ist.

11. Testverfahren für ein Halbleiterbauelement mit einem Logikabschnitt und einem Speicherabschnitt (11), die zusammen darin ausgebildet sind, wobei der Speicherabschnitt eine Betriebssteuerschaltung (12) aufweist zum Empfangen eines Eingangssignals, das eine Adresse, Daten und einen Befehl enthält, von dem Logikabschnitt und zum Ausführen einer Lese/Schreib-Operation an den Daten, wobei das Testverfahren **gekennzeichnet ist durch**;
einen ersten Schritt zum Zuführen eines Testbeginnsignals (RTE) über einen Testeingangsanschluss (20) zu dem Speicherabschnitt (11);
einem zweiten Schritt zum Schreiben der Daten in ein Testregister (16), das in einem Speicherbereich angeordnet ist, der **durch** die Adresse auswählbar ist, gemäß der Schreiboperation der Betriebssteuerschaltung (12); und
einen dritten Schritt zum Auswählen eines Testmodus (TMRW, TAC, TWLL), um den Speicherabschnitt entsprechend den in das Testregister geschriebene Daten zu prüfen.

12. Testverfahren für ein Halbleiterbauelement nach Anspruch 11, **dadurch gekennzeichnet, dass**:
das Testbeginnsignal (RTE) eine höhere Spannung als eine Betriebsspannung des Speicherabschnitts (11) besitzt; und
der erste Schritt das Erfassen eines Hochspannungstestbeginnsignals umfasst.

13. Testverfahren für ein Halbleiterbauelement nach Anspruch 11, **dadurch gekennzeichnet, dass**:
die in das Testregister geschriebenen Daten eine kodierte Testkodierung (TRGG) in dem zweiten Schritt ist; und
der dritte Schritt das Dekodieren der kodierten Testkodierung umfasst.

14. Testverfahren für ein Halbleiterbauelement nach Anspruch 11, **dadurch gekennzeichnet, dass** der zweite Schritt das Empfangen der Adresse zum Zuweisen des Testregisters (16) aufweist.

15. Testverfahren für ein Halbleiterbauelement nach Anspruch 11, **dadurch gekennzeichnet, dass** der zweite Schritt Empfangen der Daten umfasst, die in dem Testregister (16) zu speichern sind.

16. Testverfahren für ein Halbleiterbauelement nach Anspruch 11, **dadurch gekennzeichnet, dass** der zweite Schritt umfasst: Erzeugen eines Steuersignals zum Aktivieren des Schreibens von Daten in das Testregister (16) in Reaktion auf einen Schreibbefehl, der von der Betriebssteuerschaltung bereitgestellt wird, und Zuführen des Steuersignals zu dem Testregister.

17. Testverfahren für ein Halbleiterbauelement nach Anspruch 11, **dadurch gekennzeichnet**, der dritte Schritt Empfangen eines Schreibbefehls oder eines Lesebefehls für das Zugreifen auf den Speicherabschnitt (11) umfasst.

18. Testverfahren für ein Halbleiterbauelement nach Anspruch 11, **dadurch gekennzeichnet, dass** der dritte Schritt Empfangen einer Adresse und Daten zum Zugreifen auf den Speicherabschnitt (11) umfasst.

19. Testverfahren für ein Halbleiterbauelement nach Anspruch 11, **dadurch gekennzeichnet, dass** der dritte Schritt umfasst: Auswählen eines von mehreren internen Signalen entsprechend den in das Testregister (16) geschriebenen Daten.

20. Testverfahren für ein Halbleiterbauelement nach Anspruch 19, **dadurch gekennzeichnet, dass** der dritte Schritt umfasst: Auswählen eines der ausgewählten internen Signale oder eines Signals, das von dem Logikabschnitt bereitgestellt wird.

21. Testverfahren für ein Halbleiterbauelement nach Anspruch 11,
wobei der zweite Schritt Zuordnen des Testregisters zu der Adresse entsprechend dem Testbeginnsignal umfasst; und
wobei der dritte Schritt umfasst: Schreiben von Daten für das Auswählen des Testmodus in das Testregister entsprechend dem Testbeginnsignal.

## Revendications

1. Dispositif à semi-conducteur équipé d'un mode de test ayant une section logique et une section de mémoire (11) montées ensemble sur celui-ci, le dispositif à semi-conducteur étant **caractérisé en ce que** la section de mémoire comprend:
- un circuit de commande de fonctionnement (12) pour la réception d'un signal d'entrée contenant une adresse, des données et une commande provenant de la section logique et pour l'exécution d'une opération de lecture/écriture des données conformément au signal d'entrée ;
- un circuit de mémoire de test (16) connecté au circuit de commande de fonctionnement (12) et fourni dans une zone de mémorisation de la section de mémoire (11) sélectionnable à partir de l'adresse pour la mémorisation de données afin de choisir le mode de test (TMRW, TAC, TWLL) ; et
- un circuit d'écriture (15) connecté au circuit de commande de fonctionnement (12) et au circuit de mémoire de test (16) pour la génération d'un signal de commande et pour permettre l'écriture de données dans le circuit de mémoire de test (16) en réponse à une commande d'écriture envoyée par le circuit de commande de fonctionnement (12) conformément au signal d'entrée.

2. Dispositif à semi-conducteur selon la revendication 1, **caractérisé en ce que**:
- la section de mémoire (11) comporte une zone de registre et une zone de mémoire ;
- le circuit de commande de fonctionnement (12) accède à la zone de registre et à la zone de mémoire de la section de mémoire conformément au signal d'entrée ; et
- le circuit de mémoire de test est un registre de test (16) fourni dans la zone de registre et mémorise un code de test codé (TRG) pour la sélection du mode de test (TMRW, TAC, TWLL).

3. Dispositif à semi-conducteur selon la revendication 2, **caractérisé en outre par** un circuit de commande de test (14) qui est connecté au registre de test (16) pour la génération d'un signal de sélection de mode de test (TMRW, TAC, TWLL) en décodant le code test (TRG) du registre de test (16).

4. Dispositif à semi-conducteur selon la revendication 3, **caractérisé en outre pa**r un sélecteur E/S (17a, 17b) qui est connecté au circuit de commande de test (14) afin de sélectionner un d'une pluralité de signaux internes conformément au signal de sélection de mode de test (TMRW, TAC, TWLL).

5. Dispositif à semi-conducteur selon la revendication 4, **caractérisé en outre par** un commutateur (21a, 21b) qui est connecté au sélecteur E/S (17a, 17b) pour sélectionner l'un des signaux sélectionnés par le sélecteur et le signal de la section logique, le sélecteur E/S étant connecté à la borne externe (22a, 22b) par l'intermédiaire du commutateur.

6. Dispositif à semi-conducteur selon la revendication 3, **caractérisé en ce que** le circuit de commande de test (14) reçoit un signal d'entrée de test (RTE) provenant d'une borne d'entrée de test (20) située à l'extérieur de la section de mémoire.

7. Dispositif à semi-conducteur selon la revendication 6, **caractérisé en ce que**:
- le signal d'entrée de test (RTE) a une tension plus élevée que la tension de fonctionnement de la section de mémoire ; et
- le circuit de commande de test (14) comprend un circuit de détection (31) pour détecter un signal d'entrée de test à haute tension.

8. Dispositif à semi-conducteur selon la revendication 7, **caractérisé en ce que** le circuit de détection (31) produit un signal d'activation de test (TESTM) lorsqu'il détecte le signal d'entrée de test (RTE) et envoie le signal d'activation de test au registre de test (16).

9. Dispositif à semi-conducteur selon la revendication 1, **caractérisé en ce que**:
- la section de mémoire (13) comprend une zone de mémoire non volatile ;
- le circuit de commande de fonctionnement (12) accède à la zone de mémoire non volatile de la section de mémoire (13) conformément au signal d'entrée ; et
- le circuit de mémoire de test (16) est situé dans la zone de mémoire non volatile.

10. Dispositif à semi-conducteur selon la revendication 2, étant un semi-conducteur monopuce qui comprend une macro-mémoire montée sur celui-ci.

11. Procédé de test pour un dispositif à semi-conducteur ayant une section logique et une section de mémoire (11) montées ensemble sur celui-ci, la section de mémoire comprenant un circuit de commande de fonctionnement (12) pour la réception d'un signal d'entrée comprenant une adresse, des données et une commande provenant de la section logique et exécutant une opération de lecture/écriture de données, le procédé de test étant **caractérisé par** :
- une première étape consistant à envoyer un signal d'entrée de test (RTE) à la section de mémoire (11) par l'intermédiaire d'une borne d'entrée de test (20) ;
- une deuxième étape consistant à écrire des données dans un registre de test (16) situé dans une zone de mémorisation qui est sélectionnable à partir de l'adresse, conformément à l'opération d'écriture du circuit de commande de fonctionnement (12) ; et
- une troisième étape consistant à sélectionner un mode de test (TMRW, TAC, TWLL) pour tester la section de mémoire conformément aux données section de mémoire conformément aux données mémorisées dans le registre de test.

12. Procédé de test pour un dispositif à semi-conducteur selon la revendication 11, **caractérisé en ce que** :
- le signal d'entrée de test (RTE) présente une tension plus élevée qu'une tension de fonctionnement de la section de mémoire (11) ; et
- la première étape comprend la détection d'un signal d'entrée de test de haute tension.

13. Procédé de test pour un dispositif à semi-conducteur selon la revendication 11, **caractérisé en ce que** :
- les données écrites dans le registre de test sont, dans la deuxième étape, un code de test codé (TRGG) ; et
- la troisième étape comprend le décodage du code de test codé.

14. Procédé de test pour un dispositif à semi-conducteur selon la revendication 11, **caractérisé en ce que** la deuxième étape comprend la réception de l'adresse pour désigner le registre de test (16).

15. Procédé de test pour un dispositif à semi-conducteur selon la revendication 11, **caractérisé en ce que** la deuxième étape comprend la réception des données qui sont à sauvegarder dans le registre de test (16).

16. Procédé de test pour un dispositif à semi-conducteur selon la revendication 11, **caractérisé en ce que** la deuxième étape comprend la génération d'un signal de commande pour permettre l'écriture des données dans le registre de test (16) en réponse à une commande d'écriture envoyée par le circuit de commande de fonctionnement et l'envoi du signal de commande au registre de test.

17. Procédé de test pour un dispositif à semi-conducteur selon la revendication 11, **caractérisé en ce que** la troisième étape comprend la réception d'une commande d'écriture ou d'une commande de lecture pour accéder à la section de mémoire (11).

18. Procédé de test pour un dispositif à semi-conducteur selon la revendication 11, **caractérisé en ce que** la troisième étape comprend la réception d'une adresse et de données pour accéder à la section de mémoire (11).

19. Procédé de test pour un dispositif à semi-conducteur selon la revendication 11, **caractérisé en ce que** la troisième étape comprend la sélection d'un d'une pluralité de signaux internes en fonction des données écrites dans le registre de test (16).

20. Procédé de test pour un dispositif à semi-conducteur selon la revendication 19, **caractérisé en ce que** la troisième étape comprend la sélection de l'un ou l'autre du signal interne sélectionné et d'un signal envoyé par la section logique.

21. Procédé de test pour un dispositif à semi-conducteur selon la revendication 11,
- la deuxième étape comprenant la désignation d'un registre de test avec l'adresse en correspondance avec le signal d'entrée de test ;
- et la troisième étape comprenant l'écriture de données pour sélectionner le mode de test dans le registre de test correspondant au signal d'entrée de test.
